Europäisches Patentamt

European Patent Office

Office européen des brevets

(11) Publication number: **0 222 395**
A1

# EUROPEAN PATENT APPLICATION

(21) Application number: 86115725.3

(22) Date of filing: 12.11.86

(51) Int. Cl.⁴: **H 01 L 31/02**
**H 01 L 33/00**

(30) Priority: 13.11.85 JP 252615/85
18.09.86 JP 218021/86

(43) Date of publication of application:
20.05.87 Bulletin 87/21

(84) Designated Contracting States:
DE FR GB

(71) Applicant: Kabushiki Kaisha Toshiba
72, Horikawa-cho Saiwai-ku
Kawasaki-shi Kanagawa-ken 210(JP)

(72) Inventor: Chinen, Koyu Patent Division
K.K. Toshiba 1-1 Shibaura 1-chome
Minato-ku Tokyo 105(JP)

(74) Representative: Henkel, Feiler, Hänzel & Partner
Möhlstrasse 37
D-8000 München 80(DE)

(54) Improvement in electrode structure of photosemiconductor device.

(57) In an electrode structure of a photosemiconductor device, an insulating layer 14 having stripe-like opening 12 is formed on p-type semiconductor layer 10. A multi-layered electrode 16 is formed on the layer 10. The electrode 16 is obtained by sequentially depositing a first metal layer 18 of Ti, a second metal layer 20 of Zn, a third metal layer 22 of Pe and a fourth metal layer 24 of Au. The semiconductor structure is heated in an inert gas so that a PHS layer 26 of Au is formed on the layer 24.

F I G. 1

Croydon Printing Company Ltd.

- 1 -

Improvement in electrode structure of
photosemiconductor device

The present invention relates to a photosemiconductor device and, more particularly, to an improvement in an electrode structure of the photosemiconductor device.

In a photosemiconductor device such as a semiconductor laser or a light-emitting diode, a metal electrode is formed on a semiconductor layer. In a conventional photosemiconductor device, a multilayer metal film consisting of Ti/Pt/Au is used as the metal electrode.

Although the above-mentioned multilayer metal film has a good adhesive bond with the semiconductor layer, a sufficient ohmic contact cannot be obtained. In order to obtain a good ohmic contact, an Au film containing Zn as a p-type impurity is sometimes used when the semiconductor layer is a p-type semiconductor. However, again, since Au is diffused into the semiconductor layer, reliability of the device cannot be improved. In addition, when an insulating layer for narrowing a current path is formed on the semiconductor layer, the electrode metal cannot have a sufficient adhesive bond and the electrode is peeled from the insulating layer.

It is an object of the present invention to provide a photosemiconductor device having an electrode structure with a good ohmic contact and high reliability.

According to the present invention, there is provided a photosemiconductor device comprising a semiconductor chip with a semiconductor layer of a first conductivity type, a first metal layer, formed on the semiconductor layer of the first conductivity type and substantially consisting of Ti or Cr, a second metal layer, formed on the first metal layer and containing an element which determines the same conductivity type as that of semiconductor layer of the first conductivity type, a third metal layer, formed on the second metal layer and substantially consisting of Pt or Pd, and a fourth metal layer, formed on the third metal layer and substantially consisting of Au.

This invention can be more fully understood from the following detailed description when taken in conjunction with the accompanying drawings, in which:

Fig. 1 is a schematic sectional view of a light-emitting diode according to an embodiment of the present invention;

Fig. 2 is a schematic sectional view of a laser diode according to another embodiment of the present invention; and

Fig. 3 is a schematic sectional view of a laser diode according to still another embodiment of the present invention.

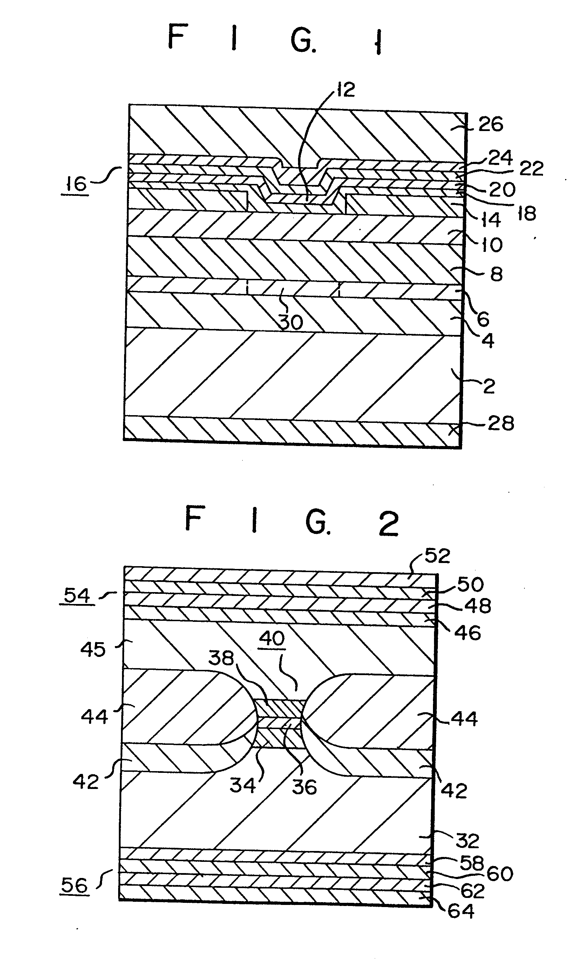

Embodiments of the present invention will now be described in detail with reference to the accompanying drawings. Fig. 1 is a sectional view of a typical embodiment wherein the present invention is applied to a light-emitting diode which emits a light beam from its end face.

In this photosemiconductor device, predetermined semiconductor layers having a heterojunction structure, i.e., n-type InP cladding layer 4, GaInAsP active layer 6, p-type InP cladding layer 8, and p-type GaInAsP cap layer 10, are sequentially formed on n-type semiconductor substrate 2 by an epitaxial growth method. Thereafter, insulating layer 14 having stripe-like opening 12 of a predetermined size for narrowing a current path is formed on layer 10 to a thickness of 2,000 to 3,000 Å. Then, p-type ohmic electrode 16 is formed on layer 14 and layer 10 in opening 12. Electrode 16 is obtained by sequentially depositing 500 Å-thick Ti as first metal layer 18, 500 Å-thick Zn as second metal layer 20, 1,000 Å-thick Pt as third metal layer 22, and 1,500 Å-thick Au as fourth metal layer 24.

After each layer of electrode 16 is formed, in order to improve an ohmic contact of electrode 16 with respect to the semiconductor layer, the above-mentioned semiconductor structure is heated in an inert gas or a reducing gas atmosphere at a temperature of 400 to 500°C for 10 seconds to 10 minutes. Then, 2 μm-thick PHS (Plated Heat Sink) layer 26 of Au is formed on layer 24.

On the other hand, n-type electrode 28 of a Ge-Pt-Au alloy layer is formed on a back surface of substrate 2.

Thereafter, a wafer on which a number of elements are formed by the above process is divided into individual semiconductor chips to obtain a predetermined photosemiconductor device. Note that in Fig. 1, reference numeral 30 denotes a light-emitting region, and this photosemiconductor device is mounted to a stem at its layer 26 side.

In the above process, Zn layer 20 between Ti and Pt layers 18 and 22 is solid-phase diffused. More specifically, Zn atoms pass through layer 18 and diffused into layer 10. A Zn diffusion layer of layer 10 into which excessive Zn atoms are doped is reduced to have a superior ohmic contact because of a small barrier potential. Note that the thickness of layer 18 is preferably 1,000 Å or less, e.g., 100 to 1,000 Å to allow diffusion of Zn atoms therethrough.

Layer 18 on layer 14 has a good adhesive bond with layer 14, and the adhesive bond is further enhanced after the heating process. Although Zn is diffused by the annealing, the diffusion is stopped at a region of layer 14 because of its relatively large thickness of 2,000 to 3,000 Å, thereby narrowing the current path.

Generally, the uppermost layer of the electrode must be formed of Au in terms of stability and reliability of the electrode. On the other hand, Zn is diffused to the side opposite to layer 18 by the annealing. If there is a thick film of Au, Zn is diffused more than in the p-type semiconductor side, thereby degrading the ohmic contact. For this reason, in order to prevent diffusion of Zn to layer 24, it is important to insert layer 22 between layers 20 and 24. Layer 22 also prevents the diffusion of Au to the semiconductor layer.

Therefore, according to the above embodiment, a photosemiconductor device with an electrode structure 6aving a good adhesive bond, a good ohmic contact, and high reliability can be obtained.

Note that Cr instead of Ti may be used as the first metal layer, and Pd instead of Pt may be used as the third metal layer. Furthermore, for the second metal layer, Group II metals such as Be or Cd may be used as a p-type dopant instead of Zn.

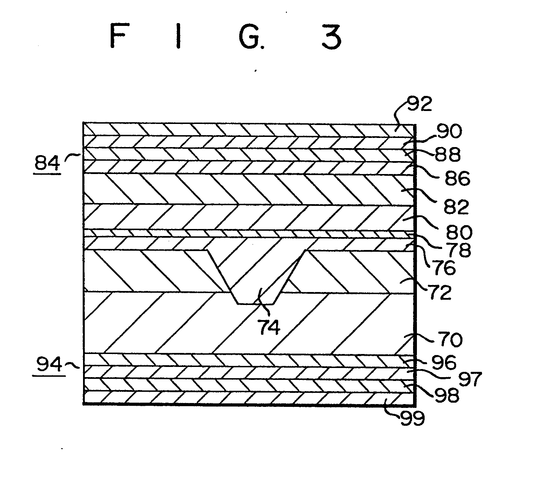

Another embodiment wherein the present invention is applied to a semiconductor laser in which a current path is narrowed will be described with reference to Fig. 2.

N-type InP cladding layer 34, InGaAsP active layer 36, and p-type InP cladding layer 38 are sequentially formed on n-type InP substrate 32 by epitaxial growth. A stripe-like mask of $SiO_2$ is formed on layer 38, and then stripe-like mesa 40 is formed by chemical etching. P-type InP blocking layer 42 and n-type InP blocking layer 44 are grown on the substrate 32 at both sides of mesa 40, and mesa 40 is buried in the resultant structure. Thereafter, the $SiO_2$ mask is removed, and p-type InGaAsP layer 45 is grown on layers 38 and 44 to form a buried semiconductor laser.

Multilayer electrode 54 of first metal layer (Ti) 46, second metal layer (Zn) 48, third metal layer (Pt) 50, and fourth metal layer (Au) 52 is formed on layer 45. Layer 48 is subjected to a solid-phase diffusion by annealing so that. Zn atoms are diffused into layer 45 through layer 46.

In order to accelerate this solid-phase diffusion, it is effective to form layer 46 into a porous structure. In this embodiment, n-type ohmic electrode 56 formed on substrate 32 is formed to be a multilayer electrode consisting of porous Ti film 58 as a first layer, Ge film 60 as a second layer, Pt film 62 as a third layer, and Au film 64 as a fourth layer. Film 58 can be formed by low temperature and low pressure deposition, e.g., under the conditions of a substrate temperature of 100°C or less and in an inert atmosphere at $10^{-5}$ Torr. In this manner, porous film 58 having a large particle size is formed, so that Ge element of layer 60 as an n-type dopant component can be effectively solid-phase diffused into substrate 32. As the n-type dopant component, Group IV elements such as Sn or Si can be used instead of Ge to obtain the same result.

The present invention can be applied to GaAlAs/ GaAs Group III - V semiconductors in stead of the above-mentioned GaInAsP/InP photosemiconductors. Fig. 3 shows an embodiment of an internal stripe type semiconductor laser. N-type GaAs blocking layer 72 for narrowing an internal current path is formed on p-type GaAs substrate 70. After groove stripe 74 is formed by chemical etching, p-type GaAlAs cladding layer 76, GaAlAs active layer 78, n-type GaAlAs cladding layer 80, and n-type GaAs ohmic layer 82 are sequentially formed. Then, a multilayer ohmic electrode of Cr 86, Ge 88, Pt 90, and Au 92 is formed in n-side electrode 84, and a multilayer ohmic electrode of Ti 96, Zn 97, Pt 98, and Au 99 is formed in p-type electrode 94. The semiconductor laser is mounted to a heat sink at the side of n-side electrode 84.

As has been described above, in the present invention, a first metal layer as an adhesive layer of Ti or Cr is formed on a semiconductor layer of a first conductivity type, a second metal layer containing a dopant element which determines the same conductivity type as that of the semiconductor layer is formed on the first metal layer, and the dopant element constituting the second metal layer is diffused into the first metal layer by annealing and reaches the semiconductor layer of the first conductivity type through the first metal layer. For this reason, a good ohmic contact is realized. At the same time, a good adhesive bond is also realized because the first metal layer serves as an adhesive metal. Note that the third metal layer of Pt or Pd formed on the second metal layer serves as a barrier layer which prevents diffusion of the element of the second metal layer into the fourth metal layer of Au formed on the third metal layer or diffusion of the element of the fourth metal layer into the second metal layer.

Note that in the embodiments described above, the description has been made for light-emitting devices such as a light-emitting diode or a laser diode. However, since photodetecting devices such as a photodetecting diode have substantially the same diode structure as that of the light-emitting devices, it is obvious that the present invention can be applied to the photodetecting devices.

According to the present invention, there is provided a photosemiconductor device with an electrode structure having a good ohmic contact, a good adhesive bond, and high reliability.

Claims:

1. In a photosemiconductor device having a semiconductor layer (10, 32, 45, 70, 82) of a first conductivity type and an electrode structure (16, 54, 56, 84, 94) formed on the semiconductor layer (10, 32, 45, 70, 82), an improvement characterized in that said electrode structure (16, 54, 56, 84, 94) comprises:

a first metal layer (18, 46, 58, 86, 96) of one of first metals Ti and Cr formed on said semiconductor layer (10, 32, 45, 70, 82) of the first conductivity type;

a second metal layer (20, 48, 60, 88, 97), formed on said first metal layer (18, 46, 58, 86, 96) and containing a second metal which determines the same conductivity type as that of said semiconductor layer (10, 32, 45, 70, 82) of the first conductivity type;

a third metal layer (22, 50, 62, 90, 98) of one of third metals Pt and Pd formed on said second metal layer (20, 48, 60, 88, 97); and

a fourth metal layer (24, 52, 92, 99) of Au formed on said third metal layer (22, 50, 62, 90, 98).

2. A device according to claim 1, characterized in that the second metal (20, 48, 60, 88, 97) is diffused into the first metal layer (18, 46, 58, 86, 96) and the semiconductor layer (10, 32, 45, 84) of the first conductivity type.

3. A device according to claim 1, characterized in that said photosemiconductor device has a heterojunction structure.

4. A device according to claim 1, characterized in that said semiconductor layer (10, 32, 45, 84) of the first conductivity type consists of a p-type semiconductor, and said second metal layer (20, 48, 60, 88, 97) contains at least a Group II metal.

5. A device according to claim 1, characterized in that said semiconductor layer (10, 32, 45, 70, 82) of the first conductivity type consists of an n-type semiconductor, and said second metal layer (20, 48, 60, 88, 97) contains at least a Group IV metal.

6. A device according to claim 1, characterized in that said first metal layer (18, 46, 58, 86, 96) has a thickness within 100 Å to 1,000 Å.

7. A device according to claim 1, characterized in that said first metal layer (18, 46, 58, 86, 96) has a porous structure.

8. A device according to claim 1, characterized in that said semiconductor layer (10, 32, 45, 70, 82) of the first conductivity type is a Group III - V compound semiconductor.

9. In a photosemiconductor device having a semiconductor layer (10) of a first conductivity type, an insulating layer (14) formed on said semiconductor layer (10) and provided with a through hole, and an electrode structure (16) formed on said insulating layer (14) and the semiconductor layer (10) and electrically contacted to the semiconductor layer (10) in the through hole; an improvement characterized in that said electrode structure (16) comprises:

a first metal layer (18) of one of first metals Ti and Cr formed on said insulating layer (14) and said semiconductor layer (10) of the first conductivity type;

a second metal layer (20), formed on said first metal layer (18) and containing a second metal which determines the same conductivity type as that of said semiconductor layer (10) of the first conductivity type;

a third metal layer (22) of one of third metals Pt and Pd formed on said second metal layer (20); and

a fourth metal layer (24) of Au formed on said third metal layer (26).

# F I G. 1

# F I G. 2

# F I G. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 156 551 (SUMITOMO ELECTRIC INDUSTRIES) * Page 3, line 8 - page 5, line 2; figure 3 * | 1-4,8, 9 | H 01 L 31/02 H 01 L 33/00 |
| A | | 5-7 | |
| A | R.C.A. REVIEW, vol. 44, no. 1, March 1983, pages 101-109, Princeton, New Jersey, US; I. LADANY et al.: "Ohmic contacts for laser diodes" | 1-9 | |
| A | US-A-4 510 514 (CAMLIBEL et al.) * Claims * | 1 | |
| A | PATENTS ABSTRACTS OF JAPAN, vol. 7, no. 107 (E-174)[1252], 11th May 1983; & JP-A-58 30 170 (STANLEY DENKI K.K.) 22-02-1983 | 1 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 23-01-1987 | GALLO G.G. |